Europäisches Patentamt

European Patent Office

Office européen des brevets

(19)

(11) EP 0 903 850 A2

(12) **EUROPEAN PATENT APPLICATION**

(43) Date of publication:
24.03.1999 Bulletin 1999/12

(51) Int Cl.⁶: **H03H 7/25**

(21) Application number: 98440210.7

(22) Date of filing: 18.09.1998

(84) Designated Contracting States:
**AT BE CH CY DE DK ES FI FR GB GR IE IT LI LU MC NL PT SE**
Designated Extension States:
**AL LT LV MK RO SI**

(30) Priority: **19.09.1997 IT MI972122**

(71) Applicant: **ALCATEL**
**75008 Paris (FR)**

(72) Inventor: **Mammarella, Carlos**
**20040 Capriano di Briosco (Milano) (IT)**

(74) Representative: **Schätzle, Albin, Dipl.-Phys. et al**
**Alcatel Alsthom**
**Intellectual Property Department,**
**Postfach 30 09 29**
**70449 Stuttgart (DE)**

(54) **A pi variable attenuator with wide attenuation dynamics, and relevant control circuit**

(57)    A $\pi$ variable attenuator with wide attenuation dynamics comprising three PIN diodes, two (DP1, DP2) pertaining to the shunt arms of the attenuator and one (DS) to the series arm, wherein to obtain the wide atten-uation dynamics through a suitable control circuit (ZB), the bias current (Is) of the series diode is made inde-pendent from the bias currents (Ip1, Ip2) of the parallel diodes.

FIG. 2

EP 0 903 850 A2

## Description

This invention refers to the field of controlled attenuation devices, i.e. to a variable $\pi$ attenuator with wide attenuation dynamics and relevant control circuit.

Variable $\pi$ attenuators presently employed for high frequency applications, such as for band 'C' (3,4 - 8,5 Ghz) application, are normally manufactured with beam-lead PIN diodes and ceramic substrates.

As regards band 'C' receivers, an NF shaped noise in the range of 1,5 - 2 dB is presently required along with their capability of ensuring correct operation at high power ranges of about -20 dBm.

According to the present state of art, these requirements in the known devices call for limitation of the gain of the first stage of the radio frequency amplifying chain and of the acceptable insertion losses of the subsequent attenuator, which is normally followed by a further RF amplifier. Moreover, attenuation dynamics of the variable attenuator is also dictated by said requirements.

Typical values of the variable attenuator specifications read:
Insertion losses <-2dB - attenuation dynamics > 20 dB; In/Out return loss < -10 dB, operating band > 1 Ghz.

Under these conditions:

- Conventional control systems of variable attenuators do not allow the achivement of the required attenuation dynamics;
- it is not possible to have a cascade arrangement of several attenuators to reach the required total attenuation dynamics, because the sum of their insertion losses exceeds the maximum acceptable limit;
- available configurations using PIN diodes in separate packages limit the application band and also have excessive losses.

Therefore, it is the object of the present invention to overcome the above mentioned drawbacks and provide for a circuit solution which allows the utilization of $\pi$-configured pin diodes as a variable attenuator for low frequency up to microwaves applications, also in band 'C', e.g. Front-End applications.

In order to achieve these objectives, the present invention provides a variable $\pi$ attenuator with wide attenuation dynamics and a relevant control circuit, as described better in the claims, which form integral part of this description.

Other objects of the present invention will become apparent from the following detailed description of an embodiment thereof and from the annexed drawings only supplied by way of a non limiting example, wherein:

- Fig. 1 shows an example of a known variable $\pi$ attenuator;
- Fig. 2 shows a variable $\pi$ attenuator, and a relevant control circuit, according to the present invention;
- Fig. 3 shows a possible circuit embodiment of the block ZB of fig. 2.

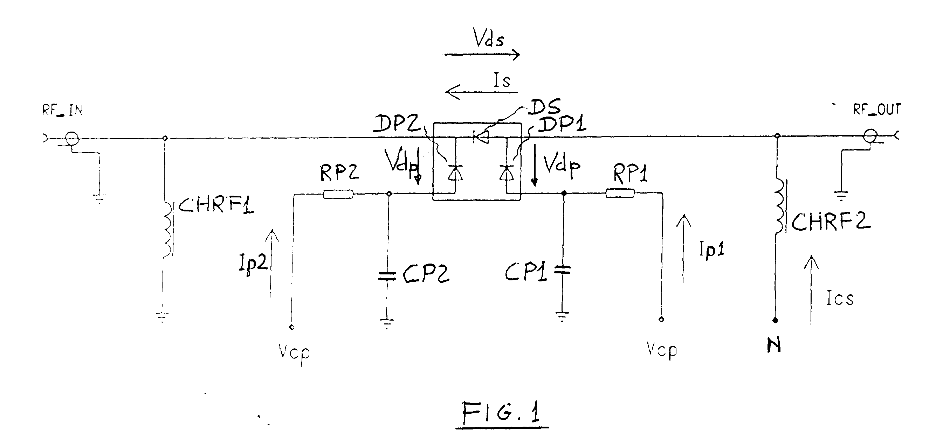

In fig. 1 there is shown a known variable PIN diode $\pi$ attenuator.

DP1 and DP2 indicate two PIN diodes pertaining to the two parallel arms and DS a PIN diode pertaining to the series arm of the variable attenuator.

Both the cathodes of DP2 and DS are connected together towards the radio-frequency signal input RF_IN, whereas the cathode of DP1 and the anode of DS are connected together towards the radio-frequency signal output RF_OUT. Applied to the anodes of DP1 and DP2 are two bias circuits consisting of a variable voltage generator Vcp generating a variable bias current Ip1 and Ip2 through respective resistances RP1 and RP2. A bias voltage Vdp is established across terminals of DP1 and DP2.

CP1 and CP2 indicate two radio-frequency shortcircuit capacitances connected between the anodes of DP1 and DP2 and ground.

CHRF1 and CHRF2 indicate two radio-frequency open-circuit inductances connected between RF_IN and ground, and between RF_OUT and node N, respectively.

Is indicates a variable bias current of the series diode DS generated by a variable current generator Ics applied to node N and fed to the anode of DS, e.g. through CHRF2. A bias voltage Vds is established across the terminals of DS.

As known, currents Is, Ip1, Ip2 change with varying Vcp and Ics values, thus allowing a change of the internal resistances of diodes DS, DP1 and DP2 and then of the attenuation introduced by the circuit of Fig. 1.

In the range of desired attenuation values the following conditions shall apply:

- minimum attenuation: Ip1 = min Ip1; Ip2 = min Ip2; Is = max Is
- maximum attenuation: Ip1 = max Ip1; Ip2 = max Ip2; Is = min Is

To obtain an input characteristic impedance of the attenuator S11 almost equal to the output characteristic impedance of S22, it has to be Ip1 $\approx$ Ip2.

As it can be seen from this analysis the trend of current Ip1 and Ip2 is opposite to the trend of Is. Moreover, since to obtain an attenuation of about 20 dB it must be Ip1 $\approx$ 100 Is, it ensues that under high attenuation conditions Ip1 has to be much higher than Is.

Since diodes DS, DP1 and DP2 are direct current connected, if currents Ip1 and Ip2 are increased, one of them tends to close at least partially on series diode DS with the increasing attenuation. For this reason Is cannot go under a certain value as it should be necessary to reach high attenuation dynamics values: therefore it is this phenomenon that limits the attenuation dynamics of the variable attenuator.

According to the invention, it has been ascertained that the problem of attenuation dynamics limitation suffered by conventional variable attenuators is associated with the interaction of the currents of the various arms of the π configuration.

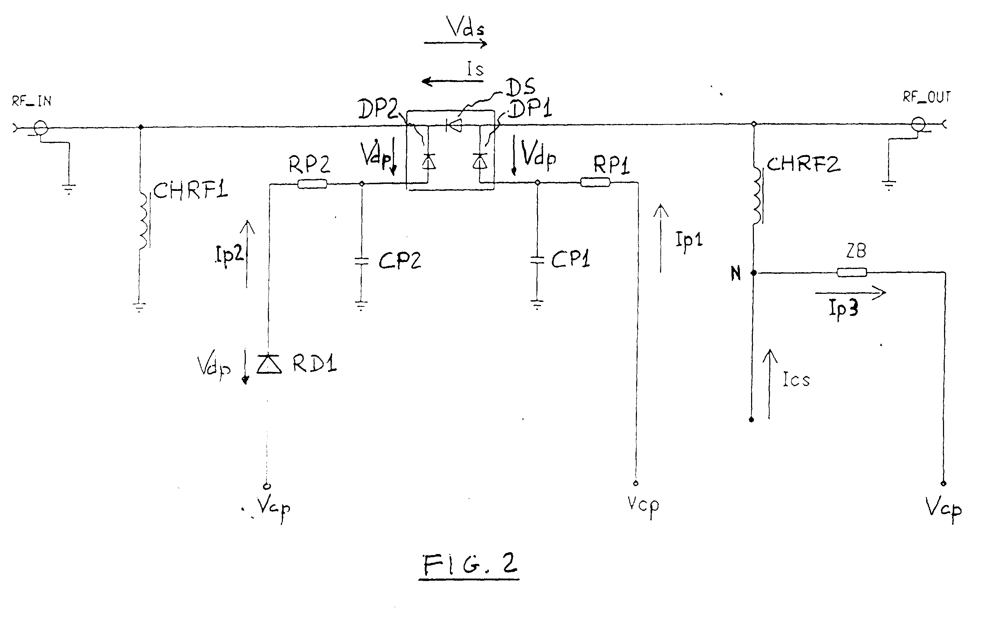

Referring to Fig. 2, in order to solve the problem, according to the invention, it has been provided a circuit ZB capable of subtracting a current Ip3 equal to the control current Ip1 from the node N. Thus, the diode DP1 can be driven as if it were not grounded (balanced mode), independently from DS.

Thereafter, it will be enough to drive the series diode DS with a grounded current generator Is (unbalanced mode) to obtain adequate isolation between currents.

Under this new condition Ics = Ip3 + Is.

In fig. 2 the same symbols are used for the circuit elements already described with reference to Fig. 1.

RD1 indicates a compensating diode having its cathode connected to RP2 and its anode connected to generator Vcp. RD1 is inserted to balance the currents of the two shunt arms so as to obtain Ip1 ≈ Ip2. Under these conditions S11 ≈ S22. Inserted between the node N and the voltage generator Vcp is a circuit ZB through which a current Ip3 ≈ Ip1 is flowing.

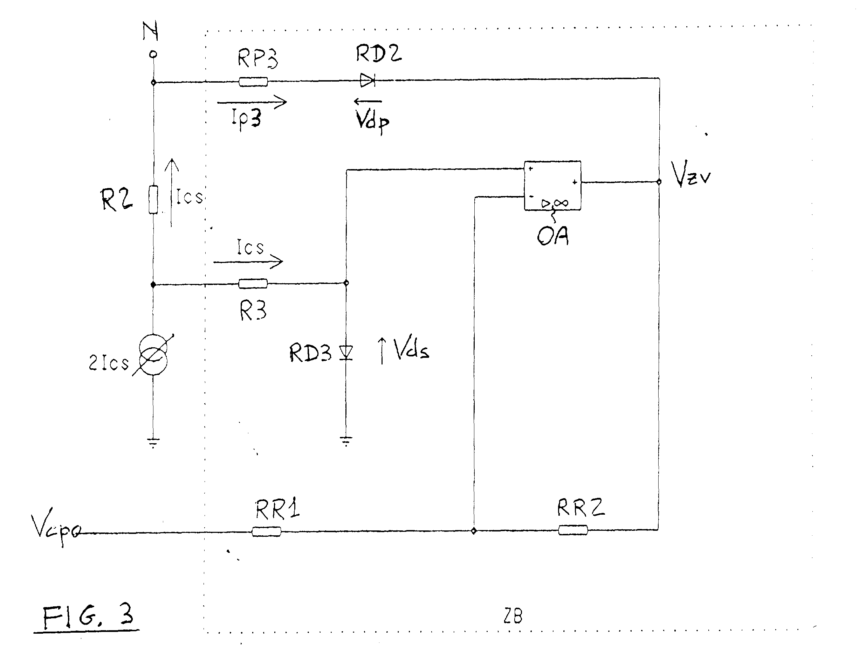

Fig. 3 highlights a possible embodiment of the circuit ZB.

RD2 and RD3 indicate two compensating diodes. Flowing through RD3 is a current Ics supplied through resistor R3 by the variable current generator 2Ics, which is also supplying an equal current Ics to the node N through R2.

RD3 has its cathode grounded and its anode connected to the non inverting input of a standard operational amplifier OA, which amplifies on direct current the input voltages.

RD2 has its cathode connected to the OA output and its anode connected to resistor RP3 also connected with the node N: a current Ip3 is flowing through RD2 and RP3.

RR1 and RR2 indicate two series connected feedback resistors: RR1 is connected between the bias voltage Vcp and the OA inverting input, whereas RR2 is connected between the latter and OA output where a voltage Vzv is established.

As to bias, i.e. d.c. bias, DS and DP2 cathodes are grounded, whereas DP1 cathode and DS anode are connected with the node N. Moreover, a selection is made between RP3 = RP1 = RP2, R2 = R3, RR1 = RR2.

Under these conditions it is shown that:

$$Ip1 = \frac{Vcp - Vdp - Vds}{RP1}$$

$$Vzv = -Vcp \frac{(RR2)}{RR1} + Vds \left(1 + \frac{RR2}{RR1}\right) = -Vcp\ 2\ Vds$$

$$Ip3 = \frac{Vds - Vzv - Vdp}{RP3} = \frac{Vds - (-Vcp + 2Vds) - Vdp}{RP3}$$

$$Ip3 = \frac{Vds + Vcp - 2Vds - Vdp}{RP3} = \frac{Vcp\ Vdp - Vds}{RP3}$$

$$Ip3 = \frac{Vcp - Vdp - Vds}{RP3}$$

Thus, it is proved that |Ip1| = |Ip3| is obtained through the circuit ZB.

Different circuit variations of the above embodiment are possible, without departing from the scope of the present invention.

For instance, each of the three PIN diodes DS, DP1, DP2 could be connected in an opposite manner with proper modifications to the relevant bias networks evident to a person skilled in the art, and/or current Is could be passed through CHRF1. However, the problem would always be the same: there would always be a bias current of one of the two shunt arms affecting the bias current of the series arm. The direction of the various bias currents depends in a known manner on the insertion direction of the relevant diodes. Then, in any case, according to the basic idea of the present invention, a circuit like ZB is inserted in the mesh of the equivalent circuit for the bias of the PIN diode of the shunt arm affecting the bias of the series arm.

Thus, we obtain that:

- the change of DS bias current Is is made independent from the change of the DP1 and DP2 bias currents Ip1 and Ip2;
- as regards biasing, the PIN diode of the shunt arm affecting the bias of the series arm is driven in an unbalanced mode, i.e. not grounded, whereas the PIN diode of the series arm is driven in a balanced mode, i.e. grounded.

The equivalent bias circuit of the variable attenuator object of the invention consists of three independent meshes, one for each PIN diode, so that the bias currents of both the shunt and series arms cannot flow through the series arm, but will close outside.

The advantages deriving from the present invention are clearly apparent from the above description.

The variable attenuator and the relevant control circuit object of this invention have a first essential advantage of a considerable cost saving as compared with the attenuators presently in use, which consist of beam-lead PIN diodes and ceramic substrates for a whole Front-End construction in one substrate alone.

Moreover, π-configurations of PIN diodes available on the market, such as SMT (Surface Mount Technology) packages can also be used for high frequencies in band 'C', ensuring a further cost reduction.

As a further advantage, the use of Lange-type couplers is no longer needed, whereas they are required in the known circuits to adapt both the input and output impedances of the attenuator. Lange couplers are highly expensive components whose usable frequency band is restricted as it is dependent on their geometrical form. In the attenuator object of the present invention, on the contrary, said Lange couplers to adapt both the input and output impedances are replaced by the control of the bias currents, thus obtaining a circuit capable of operating in a very broad frequency band, only limited by the parasitic capacitances of the applied diodes.

## Claims

1.  A π variable PIN diode attenuator with wide attenuation dynamics, comprising a series arm with at least a series diode (DS), two shunt arms each one with at least a parallel PIN diode (DP1, DP2), bias means supplying bias currents for the control of said series and parallel PIN diodes, characterized in that said bias means (ZB, Vcp, Ics) supply a bias current (Is) of the series PIN diode, which is independent from the bias currents (Ip1, Ip2) of the parallel PIN diodes.

2.  A variable PIN diode attenuator according to claim 1, characterized in that said bias currents (Ip1, Ip2) of both parallel PIN diodes do not flow through said series PIN diode, but are grounded outside.

3.  A variable PIN diode attenuator according to claim 1 or 2, characterized in that said bias means (ZB, Vcp, Ics) control said series PIN diode (DS) in an unbalanced mode, i.e. grounded for biasing, and the one (DP1) of said parallel PIN diodes that would affect the bias current of the series PIN diode, in a balanced mode, i.e. not grounded for biasing.

4.  A variable PIN diode attenuator according to any of claims 1 to 3, characterized in that said bias means (ZB, Vcp, Ics) comprise:

    -   first current generating means (Vcp, RD1, RP1, RP2) connected, for biasing, with the anodes of said parallel PIN diodes (DP1, DP2) to generate said bias currents (Ip1, Ip2) of the parallel PIN diodes with a substantially equal value;
    -   second current generating means (Ics) connected, for biasing, with the anode of said series PIN diode (DS) to generate a current equal to the sum of said bias current (Is) of the series PIN diode and one (Ip1) of said bias currents of said parallel PIN diodes;
    -   a subtraction circuit (ZB, Vcp) connected in parallel with said second current generating means (Ics), which causes a current equal to said one (Ip1) of said bias currents of said parallel PIN diodes to flow through it, so that the latter is prevented from flowing through said series PIN diode (DS).

5.  A variable PIN diode attenuator according to any of claims 1 to 4, characterized in that said series PIN diode (DS) and said parallel PIN diodes (DP1, DP2) are housed in a single SMT (Surface Mount Technology) package.

6.  A control circuit for a variable PIN diode π attenuator with wide attenuation dynamics, said attenuator comprising a series arm with at least one series PIN diode (DS), two parallel arms, each with at least one parallel PIN diode (DP1, DP2), said control circuit comprising bias means supplying bias currents for the control of said series and parallel PIN diodes, characterized in that said bias means (ZB, Vcp, Ics) supply a bias current (Is) of the series PIN diode independent from the bias currents (Ip1, Ip2) of the parallel PIN diodes.

7.  A control circuit according to claim 6, characterized in that said bias currents (Ip1, Ip2) of both the parallel PIN diodes do not flow through said series PIN diode, but are grounded outside.

8.  A control circuit according to claim 6 or 7, characterized in that said bias means (ZB, Vcp, Ics) monitor said series PIN diode (DS) in an unbalanced mode, i.e. grounded for biasing, and the one of said parallel PIN diodes (DP1) that would affect the bias current of the series PIN diode, in a balanced mode, i.e. not grounded for biasing.

9.  A control circuit according to any of claims 6 to 8, characterized in that said bias means /ZB, Vcp, Ics) comprise:

    -   first current generating means (Vcp, RD1, RP1, RP2) connected, for biasing, with the anodes of said parallel PIN diodes (DP1, DP2) to generate said bias currents (Ip1, Ip2) of the parallel PIN diodes with a substantially equal value;
    -   second current generating means (Ics) connected, for biasing, with the anode of said series PIN diode (DS) to generate a current equal to the sum of said bias current (Is) of the series PIN diode and one (Ip1) of said bias currents of said parallel pin diodes;
    -   a subtraction circuit (ZB, Vcp) connected in parallel with said second current generating means (Ics), which causes a current equal to said one (Ip1) of said bias currents of said parallel PIN diodes to flow through it, so that the latter is prevented from flowing through said series PIN diode (DS).

10. A control circuit according to any of claims 6 to 9, characterized in that said series PIN diode (DS) and said parallel PIN diodes (DP1, DP2) are housed in a single SMT (Surface Mount Technology) package.

FIG.1

FIG. 2

N

RP3          RD2

$I_{p3}$      $\overline{V_{dp}}$

R2    ↑$I_{cs}$

$I_{cs}$

R3

$2I_{cs}$

RD3 ▽    ↑$V_{ds}$

$V_{zv}$

OA

$V_{cpo}$          RR1                    RR2

# FIG. 3

ZB